# EUROPEAN PATENT APPLICATION

(11) **EP 4 815 028 A1**
(43) Date of publication of application: **30.09.2026**
(21) Application number: 25770124.3
(22) Date of filing: 31.01.2025
(51) Int. Cl.: H01J 40/18, H10F 77/00

(54) **PHOTODETECTOR**

(30) Priority: 13.03.2024 JP 2024038814
(71) Applicant: Hamamatsu Photonics K.K., Hamamatsu-shi, Shizuoka 435-8558 (JP)
(72) Inventor: FUKASAWA, Atsuhito, Hamamatsu-shi, Shizuoka 435-8558 (JP); EGAWA, Yasuyuki, Hamamatsu-shi, Shizuoka 435-8558 (JP); KIMURA, Suenori, Hamamatsu-shi, Shizuoka 435-8558 (JP); KOYAMA, Hiroaki, Hamamatsu-shi, Shizuoka 435-8558 (JP)
(74) Representative: Grünecker Patent- und Rechtsanwälte PartG mbB
(86) International application number: PCT/JP2025/003247
(87) International publication number: WO 2025/192085

(57) **Abstract**

A photodetector 1 comprises: a vacuum housing 2 having a window part 12; a photoelectric surface (first photoelectric conversion layer) 3 configured to emit electrons E in accordance with incidence of light L1; a phosphor layer (second photoelectric conversion layer) 4 configured to generate light L2 in accordance with incidence of the electrons E emitted from the photoelectric surface 3; and a semiconductor photodetection element 5 arranged on an opposite side of the photoelectric surface 3 so that the phosphor layer 4 is sandwiched therebetween and configured to detect the light L2 generated from the phosphor layer 4. The semiconductor photodetection element 5 is arranged to be separated from the phosphor layer 4.

## Description

### Technical Field

The present disclosure relates to a photodetector.

### Background Art

In high-energy physics experiments such as cosmic ray detection experiments and accelerator experiments, photodetectors capable of detecting single photons are used. As a conventional photodetector, there is a so-called hybrid photodetector (HPD) in which a photoelectric surface and a semiconductor element such as an avalanche photodiode are arranged inside a vacuum housing. Although electrons emitted from the photoelectric surface are directly detected by the semiconductor element in the hybrid photodetector, a gain required for detecting a single photon is high and it is necessary to drive the semiconductor element at a high voltage therefor.

To drive a semiconductor photodetection element at a lower voltage, a photodetector in which electrons emitted from a photoelectric surface are temporarily converted into light, and the light after the conversion is detected by the semiconductor photodetection element has been studied. As such a photodetector, for example, there is a pixel sensor described in Patent Literature 1. In this conventional photodetector, a photoelectric surface and a semiconductor photodetection element having a phosphor layer on its surface are arranged inside a vacuum housing.

### Citation List

### Patent Literature

[Patent Literature 1] Japanese Translated PCT Patent Application Publication No. 2003-507870

### Summary of Invention

### Technical Problem

In a photodetector as described in Patent Literature 1, some of electrons emitted from a photoelectric surface may be reflected inside a vacuum housing and become reflected electrons. Inside the vacuum housing, an electric field is formed so that electrons emitted from the photoelectric surface are focused onto a phosphor layer. Therefore, it is conceivable that reflected electrons that deviate from a trajectory toward the phosphor layer again move toward the phosphor layer. If such reflected electrons deviate from the phosphor layer and collide with the semiconductor photodetection element, a peripheral wiring portion, and the like, damage may occur to the semiconductor photodetection element.

The present disclosure has been made in view of the above-described problem, and an objective thereof is to provide a photodetector capable of protecting a semiconductor photodetection element from reflected electrons generated inside a vacuum housing.

### Solution to Problem

The subject matter of the present disclosure is as follows.
[1] A photodetector comprising: a vacuum housing having a window part for causing light serving as a detection target to be incident; a first photoelectric conversion layer arranged inside the vacuum housing and configured to emit electrons in accordance with incidence of the light; a second photoelectric conversion layer arranged inside the vacuum housing and configured to generate light in accordance with incidence of the electrons emitted from the first photoelectric conversion layer; and a semiconductor photodetection element arranged on an opposite side of the first photoelectric conversion layer so that the second photoelectric conversion layer is sandwiched inside the vacuum housing and configured to detect the light generated from the second photoelectric conversion layer, wherein the semiconductor photodetection element is arranged to be separated from the second photoelectric conversion layer.
   In this photodetector, the semiconductor photodetection element is arranged to be separated from the second photoelectric conversion layer. Thereby, when some of the electrons emitted from the first photoelectric conversion layer are reflected inside the vacuum housing and become reflected electrons, even if the reflected electrons, which deviate from a trajectory toward the second photoelectric conversion layer, move again toward the phosphor layer due to the electric field in the vacuum housing, it is possible to reduce a possibility that the reflected electrons collide with the semiconductor photodetection element. Therefore, in this photodetector, the semiconductor photodetection element can be protected from reflected electrons generated inside the vacuum housing.
[2] The photodetector according to [1], wherein an internal housing surrounding the semiconductor photodetection element is arranged inside the vacuum housing. In this case, reflected electrons directed toward the semiconductor photodetection element can be physically blocked by the internal housing. Therefore, it is possible to more reliably prevent the reflected electrons from colliding with the semiconductor photodetection element.
[3] The photodetector according to [2], wherein a separation distance of the semiconductor photodetection element from the second photoelectric conversion layer is defined by the internal housing. In this case, the separation distance between the second photoelectric conversion layer and the semiconductor photodetection element can be formed as designed. Therefore, it is possible to more reliably reduce the likelihood that reflected electrons collide with the semiconductor photodetection element.
[4] The photodetector according to [2] or [ 3], wherein the internal housing has a hole that causes an internal space of the vacuum housing and an internal space of the internal housing to communicate with each other. In this case, when the vacuum housing is evacuated, the evacuation of the internal housing can be simultaneously performed via the hole. Thereby, the deterioration of the first photoelectric conversion layer due to residual gas inside the vacuum housing and the internal housing can be suppressed.
[5] The photodetector according to [4], wherein the semiconductor photodetection element is arranged on a bottom portion of the internal housing, and wherein the hole is formed, in the bottom portion, around the semiconductor photodetection element. According to such a configuration, the hole of the internal housing and the semiconductor photodetection element can be brought sufficiently close to each other. Therefore, even if the internal housing has the hole, it is possible to suppress the collision of reflected electrons with the semiconductor photodetection element through the hole.
[6] The photodetector according to [4] or [5], wherein a chip tube serving as an exhaust port of the vacuum housing and an introduction port for an alkali for use in alkalization of the first photoelectric conversion layer is provided on a bottom portion of the vacuum housing, and wherein the chip tube is arranged at a position that does not overlap the internal housing in a front view of the window part. According to such a configuration, a sufficient spacing can be formed between the hole of the internal housing and the chip tube. Therefore, even if the internal housing has the hole, it is possible to suppress the adhesion of the alkali introduced from the chip tube to the semiconductor photodetection element through the hole. This contributes to the suppression of noise (such as a dark current) caused by the adhesion of the alkali to the semiconductor photodetection element.
[7] The photodetector according to any one of [2] to [6], wherein the internal housing is formed of a conductive material. In this case, a field-free environment can be established inside the internal housing, and the formation of an electric field that directs reflected electrons toward the semiconductor photodetection element can be suppressed. Therefore, even if the reflected electrons move toward the inside of the internal housing, a possibility that the reflected electrons will collide with the semiconductor photodetection element can be sufficiently reduced.
[8] The photodetector according to any one of [2] to [7], wherein, in the second photoelectric conversion layer, a metal layer is arranged on a surface facing the first photoelectric conversion layer. In this case, a component directed toward the first photoelectric conversion layer within the light generated from the second photoelectric conversion layer can be reflected by the metal layer and move toward the semiconductor photodetection element. Therefore, an amount of light detected by the semiconductor photodetection element can be increased.
[9] The photodetector according to [8], wherein the metal layer is electrically connected to the internal housing. In this case, power can be supplied to the metal layer together with the internal housing. When power is supplied to the metal layer, the metal layer can function as an electrode that forms an electric field for guiding electrons emitted from the first photoelectric conversion layer to the second photoelectric conversion layer.
[10] The photodetector according to any one of [1] to [9], wherein an area of the first photoelectric conversion layer is larger than that of the second photoelectric conversion layer, and wherein an area of the second photoelectric conversion layer is larger than that of the semiconductor photodetection element. In this case, it is possible to improve response characteristics of the semiconductor phodetection element by reducing the area of the semiconductor photodetection element. Although it is necessary to secure a sufficient area of the first photoelectric conversion layer to improve light collection efficiency in reducing the area of the semiconductor photodetection element, it becomes unnecessary to focus electrons emitted from the first photoelectric conversion layer onto a minute region by making the area of the second photoelectric conversion layer interposed between the first photoelectric conversion layer and the semiconductor photodetection element larger than that of the semiconductor photodetection element. Because precise control of electron trajectories becomes unnecessary, the complication of the design of the photodetector can be avoided.
[11] The photodetector according to any one of [1] to [10], wherein the vacuum housing is formed of a conductive material, wherein a focusing electrode that focuses the electrons emitted from the first photoelectric conversion layer onto the second photoelectric conversion layer is arranged inside the vacuum housing, and wherein the focusing electrode has the same potential as the vacuum housing. According to such a configuration, electrons emitted from the first photoelectric conversion layer can be efficiently guided toward the second photoelectric conversion layer.
[12] The photodetector according to any one of [1] to [11], wherein a light guide member, which guides the light generated from the second photoelectric conversion layer to the semiconductor photodetection element, is arranged between the second photoelectric conversion layer and the semiconductor photodetection element. In this case, the light generated from the second photoelectric conversion layer can be efficiently guided toward the semiconductor photodetection element. Moreover, even if ions are generated due to a collision between residual gas inside the vacuum housing and electrons, ions passing through the second photoelectric conversion layer toward the semiconductor photodetection element can be physically blocked by the light guide member. Therefore, the semiconductor photodetection element can be protected from ion collisions.

### Advantageous Effects of Invention

According to the present disclosure, it is possible to protect a semiconductor photodetection element from reflected electrons generated inside a vacuum housing.

### Brief Description of Drawings

FIG. 1 is a schematic cross-sectional view showing a configuration of a photodetector according to an embodiment of the present disclosure.
FIGS. 2(a) and 2(b) are diagrams showing evaluation test results of incidence efficiency of electrons from a photoelectric surface to a phosphor layer.
FIGS. 3(a) and 3(b) are diagrams showing evaluation test results of incidence efficiency of electrons from a photoelectric surface to a phosphor layer.
FIGS. 4(a) and 4(b) are diagrams showing simulation results of trajectories of reflected electrons generated from a surface of a phosphor layer.

### Description of Embodiments

Hereinafter, a preferred embodiment of a photodetector according to an aspect of the present disclosure will be described in detail with reference to the drawings.

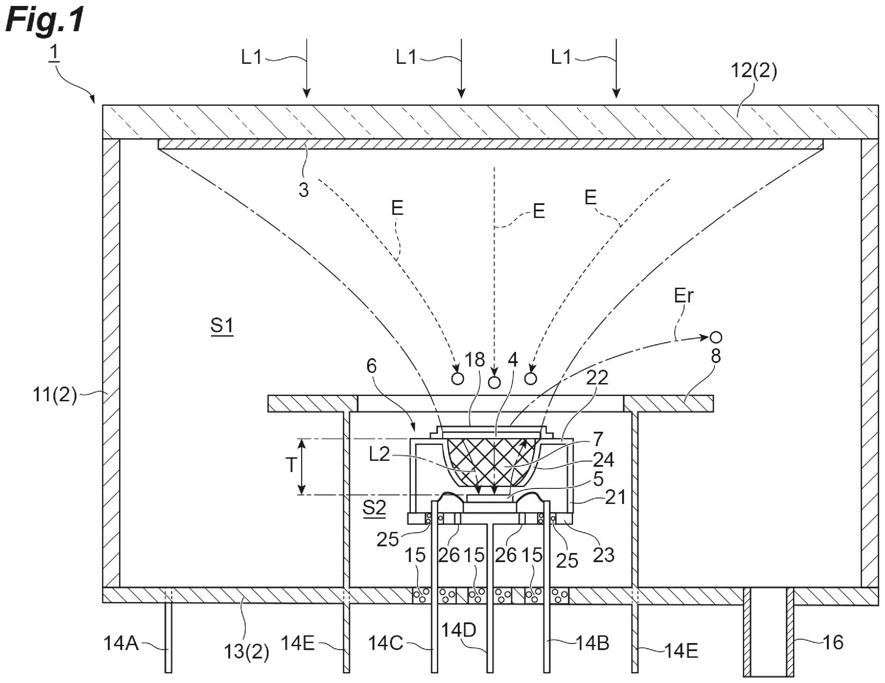

FIG. 1 is a schematic cross-sectional view showing a configuration of a photodetector according to an embodiment of the present disclosure. A photodetector 1 shown in FIG. 1 is configured, for example, as a photodetector capable of detecting single photons in high-energy physics experiments such as cosmic ray detection experiments and accelerator experiments. As shown in FIG. 1, the photodetector 1 includes a vacuum housing 2. Inside the vacuum housing 2, a photoelectric surface (first photoelectric conversion layer) 3, a phosphor layer (second photoelectric conversion layer) 4, a semiconductor photodetection element 5, an internal housing 6, a light guide member 7, and a focusing electrode 8 are arranged.

The vacuum housing 2 includes, for example, a side tube 11, a window part 12, and a stem 13. An internal space S1 of the vacuum housing 2 is defined by the side tube 11, the window part 12, and the stem 13, and is maintained in a vacuum state. A degree of vacuum of the internal space S1 is, for example, about 10⁻⁶ Pa to 10⁻⁵ Pa.

The side tube 11 is a base portion of the vacuum housing 2. The side tube 11 has, for example, a cylindrical shape with both ends open in an axial direction. As a constituent material of the side tube 11, for example, there are an iron-nickel (FeNi) alloy, a stainless (FeCrNi) alloy, a Kovar (FeCoNi) alloy, ceramic, glass, and the like. The side tube 11 may be formed of a conductive material. In a case where the photodetector 1 is used in a high-energy physics experiment, when it is necessary to exclude the presence of radioactive isotopes, it is preferable to use an iron-nickel (FeNi) alloy that does not contain cobalt (Co). In the present embodiment, the side tube 11 is formed of an iron-nickel (FeNi) alloy, which is a conductive material.

The window part 12 is a part that causes light L1 serving as a detection target to be incident inside the vacuum housing 2. The window part 12 is provided in a disk shape to close one end of the side tube 11 in the axial direction. As a constituent material of the window part 12, for example, there is a glass material such as synthetic quartz. For joining the window part 12 and the side tube 11, for example, an aluminum (Al) seal or a brazing material is used. When the window part 12 is made of synthetic quartz, it is preferable to perform thermocompression bonding using an aluminum (Al) seal.

The stem 13 is a part constituting a bottom portion of the vacuum housing 2. The stem 13 is provided in a disk shape to close the other end of the side tube 11 in the axial direction. As a constituent material of the stem 13, for example, there is Kovar metal. A plurality of stem pins 14 are inserted through the stem 13. The stem pins 14 include a power supply pin 14A for supplying power to the vacuum housing 2 (photoelectric surface 3), a power supply pin 14B for supplying power to the semiconductor photodetection element 5, an output pin 14C for extracting a signal from the semiconductor photodetection element 5, a ground pin 14D for setting the internal housing 6 to be described below to a ground potential, a power supply pin 14E for supplying power to the focusing electrode 8 to be described below, and the like. These stem pins 14 and the stem 13 are electrically insulated from each other by an insulating material 15 such as glass.

Moreover, a chip tube 16 is provided on the stem 13. The chip tube 16 is a part used as an exhaust port of the vacuum housing 2 and an introduction port for an alkali for use in alkalization of the photoelectric surface 3 in a manufacturing process of the photodetector 1. The chip tube 16 is arranged at a position outside the arrangement position of the stem pins 14 and closer to the side tube 11. Thereby, the chip tube 16 is arranged at a position that does not overlap the internal housing 6 in a front view of the window part 12. In addition, when the size of the photodetector 1 is small, the arrangement of the chip tube 16 may be omitted.

The photoelectric surface 3 is a part that emits electrons E in accordance with the incidence of the light L1. The photoelectric surface 3 is arranged inside the vacuum housing 2. In the present embodiment, the photoelectric surface 3 is provided in a circular shape on an internal surface (a surface facing the internal space S1) of the window part 12. Moreover, the photoelectric surface 3 is a transmissive alkali photoelectric surface. As alkalis for use in the photoelectric surface 3, for example, there are potassium (K), cesium (Cs), sodium (Na), and the like.

The phosphor layer 4 is a part that generates light L2 in accordance with the incidence of the electrons E emitted from the photoelectric surface 3. As a material for forming the phosphor layer 4, for example, there are a compound semiconductor such as GaN, ZnO, and the like. In the phosphor layer 4, a metal layer 18 is arranged on a surface facing the photoelectric surface 3. As a constituent material of the metal layer 18, for example, there is aluminum (Al). The metal layer 18 has a function of reflecting a component directed toward the photoelectric surface 3 within the light L2 generated from the phosphor layer 4 with the metal layer 18 and moving the reflected component to the semiconductor photodetection element 5. Moreover, when power is supplied to the metal layer 18, the metal layer 18 can function as an electrode that forms an electric field for guiding the electrons E emitted from the photoelectric surface 3 to the phosphor layer 4.

The semiconductor photodetection element 5 is a part that detects the light L2 generated from the phosphor layer 4. As the semiconductor photodetection element 5, for example, there are a silicon photomultiplier (SiPM), an avalanche photodiode (APD), a photodiode (PD), and the like. The semiconductor photodetection element 5 outputs a signal corresponding to an amount of light L2 that has been detected to the outside of the photodetector 1 via the output pin 14C.

In the present embodiment, an area of the photoelectric surface 3 is larger than that of the phosphor layer 4, and the area of the phosphor layer 4 is larger than that of the semiconductor photodetection element 5. That is, when the area of the photoelectric surface 3 is denoted by P1, the area of the phosphor layer 4 is denoted by P2, and the area of the semiconductor photodetection element 5 is denoted by P3, a relationship of P1 > P2 > P3 is satisfied. It is possible to improve response characteristics of the semiconductor photodetection element 5 by reducing the area P3 of the semiconductor photodetection element 5. Although it is necessary to sufficiently secure the area P1 of the photoelectric surface 3 so as to improve collection efficiency of the light L1 in reducing the area P3 of the semiconductor photodetection element 5, it becomes unnecessary to focus the electrons E emitted from the photoelectric surface 3 onto a minute region by making the area P2 of the phosphor layer 4 interposed between the photoelectric surface 3 and the semiconductor photodetection element 5 larger than the area P3 of the semiconductor photodetection element 5. Because precise control of electron trajectories becomes unnecessary, the complication of the design of the photodetector 1 can be avoided.

The internal housing 6 is a housing provided to surround the semiconductor photodetection element 5, inside the vacuum housing 2. The internal housing 6 is arranged near the stem 13 at a central portion of the side tube 11 in the axial direction, in the internal space S1 of the vacuum housing 2. An internal space S2 of the internal housing 6 is separated from the internal space S1 of the vacuum housing 2 by the internal housing 6. The internal housing 6 is formed, for example, of a conductive material. As the conductive material, for example, there is an (FeNi) alloy or the like, as in the side tube 11 of the vacuum housing 2. In a case where the photodetector 1 is used in a high-energy physics experiment, when it is necessary to exclude the presence of radioactive isotopes, it is preferable to use an iron-nickel (FeNi) alloy that does not contain cobalt (Co).

The internal housing 6 includes, for example, a side tube 21, a window part 22, and a bottom portion 23. The side tube 21 has, for example, a cylindrical shape having a slightly larger diameter than the semiconductor photodetection element 5. The window part 22 is provided at one end of the side tube 21 (an end facing the photoelectric surface 3). An inwardly protruding tubular part 24, which protrudes toward the inside of the side tube 21, is provided on a central portion of the window part 22. The tubular part 24 is formed, for example, so that its diameter gradually decreases toward the inside of the side tube 21. Both one end (an end facing the photoelectric surface 3) and the other end (an end facing the semiconductor photodetection element 5) of the tubular part 24 are open. A size of the opening on the one end side of the tubular part 24 is, for example, approximately the same as that of the semiconductor photodetection element 5. When the tubular part 24 is viewed from the photoelectric surface 3 side, the semiconductor photodetection element 5 is visible through the tubular part 24.

The above-described phosphor layer 4 is joined to an outer surface of the window part 22 of the internal housing 6 so that the opening at the one end of the tubular part 24 is closed. Moreover, the metal layer 18 provided on the phosphor layer 4 extends outward from an edge of the phosphor layer 4 and is joined to the window part 22 of the internal housing 6. For example, a conductive adhesive can be used for joining the phosphor layer 4 and the window part 22 and joining the metal layer 18 and the window part 22. Therefore, the phosphor layer 4 and the internal housing 6 are electrically connected to each other, and the metal layer 18 and the internal housing 6 are electrically connected to each other.

The bottom portion 23 is provided in a disk shape to close the other end of the side tube 21 (an end facing the stem 13). The power supply pin 14B and the output pin 14C described above are inserted through the bottom portion 23. These stem pins 14 and the bottom portion 23 are electrically insulated from each other by an insulating material 25 such as glass. Moreover, the above-described ground pin 14D is electrically connected to the bottom portion 23. On an internal surface of the bottom portion 23, the above-described semiconductor photodetection element 5 is arranged in a state in which it is separated from the phosphor layer 4 in the axial direction of the side tube 11. The semiconductor photodetection element 5 is joined to a central portion of the internal surface of the bottom portion 23 so as to face the phosphor layer 4 via the tubular part 24. The semiconductor photodetection element 5 is electrically connected to the power supply pin 14B and the output pin 14C inserted through the bottom portion 23.

A separation distance T between the phosphor layer 4 and the semiconductor photodetection element 5 is defined by the internal housing 6. In the example of FIG. 1, the separation distance T is a distance between a surface of the phosphor layer 4 on the semiconductor photodetection element 5 side and a surface of the semiconductor photodetection element 5 on the phosphor layer 4 side, and is mainly defined by adjusting a length of the side tube 11 in the axial direction. For example, an inorganic adhesive can be used for joining the semiconductor photodetection element 5 and the bottom portion 23. The adhesive may be either a conductive adhesive or a non-conductive adhesive. As an example of the adhesive, for example, a nano-metal paste such as nano-silver paste may be used. By applying the nano-metal paste to a joining region and firing it, a solvent evaporates and metal nanoparticles remain, and the metal nanoparticles aggregate and melt, thereby enabling the joining of members to be joined.

The internal housing 6 has a hole 26 that causes the internal space S1 of the vacuum housing 2 and the internal space S2 of the internal housing 6 to communicate with each other. By means of the hole 26, the degree of vacuum of the internal space S2 of the internal housing 6 becomes approximately the same as the degree of vacuum of the internal space S1 of the vacuum housing 2. In the present embodiment, the hole 26 is arranged, in the bottom portion 23, around the semiconductor photodetection element 5. The number of holes 26 is not particularly limited, but a plurality of holes 26 may be arranged at a predetermined phase angle around the semiconductor photodetection element 5. The position of the hole 26 is, for example, closer to the center side than insertion positions of the power supply pin 14B and the output pin 14C. Thereby, in a front view of the window part 12, the position of the hole 26 is closer to the semiconductor photodetection element 5 than the insertion positions of the power supply pin 14B and the output pin 14C.

The light guide member 7 is a part that guides the light L2 generated from the phosphor layer 4 to the semiconductor photodetection element 5. The light guide member 7 is arranged between the phosphor layer 4 and the semiconductor photodetection element 5. In the present embodiment, the light guide member 7 is arranged within the tubular part 24 of the internal housing 6. Various configurations may be applied to the light guide member 7. The light guide member 7, for example, may include synthetic quartz having a light-reflective film such as an aluminum (Al) film vapor-deposited on its surface, or may include a metal reflective plate formed on an internal wall surface of the tubular part 24. When the light L2 from the phosphor layer 4 moves to the semiconductor photodetection element 5 with a sufficient amount of light, the arrangement of the light guide member 7 may be omitted. In this case, the tubular part 24 may also be omitted, and a configuration in which a simple opening is provided in the window part 22 may be adopted.

The focusing electrode 8 is a part that forms an electric field for focusing the electrons E emitted from the photoelectric surface 3 onto the phosphor layer 4. The focusing electrode 8 has, for example, a circular frame shape, and is arranged to surround the phosphor layer 4 at a position slightly closer to the photoelectric surface 3 of the window part 12 than the phosphor layer 4. The above-described power supply pin 14E is electrically connected to the focusing electrode 8. As a constituent material of the focusing electrode 8, for example, there are an iron-nickel (FeNi) alloy, a stainless (FeCrNi) alloy, a Kovar (FeCoNi) alloy, and the like. When the size of the photoelectric surface 3 is not so large relative to the size of the phosphor layer 4, the arrangement of the focusing electrode 8 may be omitted. In this case, the power supply pin 14E may also be omitted.

When the light L1 is detected in the above-described photodetector 1, a negative high voltage (e.g., about -3 kV) is applied to the vacuum housing 2 (photoelectric surface 3) via the power supply pin 14A, and a drive voltage (e.g., on the order of several tens to several hundreds of kilovolts (kV)) is applied to the semiconductor photodetection element 5 via the power supply pin 14B. Moreover, a negative high voltage having approximately the same level as that of the vacuum housing 2 (photoelectric surface 3) is applied to the focusing electrode 8 via the power supply pin 14E. The internal housing 6, the phosphor layer 4, and the metal layer 18, which are electrically connected to the ground pin 14D, are all at the ground potential.

In this state, if the light L1 serving as the detection target is incident on the window part 12 of the photodetector 1, electrons E are emitted from the photoelectric surface 3 in accordance with the incidence of the light L1. The electrons E emitted from the photoelectric surface 3 are guided to the phosphor layer 4 according to an electric field formed by the focusing electrode 8 and the metal layer 18 in cooperation. If the electrons E are incident on the phosphor layer 4, light L2 is generated from the phosphor layer 4 in accordance with the incidence of the electrons E. The light L2 generated from the phosphor layer 4 is guided by the light guide member 7 and is incident on the semiconductor photodetection element 5. In the semiconductor photodetection element 5, a signal corresponding to an amount of light, which is the detected light L2, is generated. The signal is output to the outside from the photodetector 1 via the output pin 14C. In addition, the polarity of the voltage applied to the photodetector 1 is not limited to this, and it is only necessary for a relationship in which the electrons E emitted from the photoelectric surface 3 move toward the phosphor layer 4 to be established. For example, it is only necessary for the potential of the phosphor layer 4 to be relatively positive with respect to the photoelectric surface 3.

In an operation of the photodetector 1, some of the electrons E emitted from the photoelectric surface 3 may be reflected inside the vacuum housing 2 (e.g., on a surface of the phosphor layer 4) to become reflected electrons Er. In the vacuum housing 2, an electric field is formed by the focusing electrode 8 and the metal layer 18 in cooperation so that the electrons emitted from the photoelectric surface 3 are focused onto the phosphor layer. Therefore, it is conceivable that the reflected electrons Er, which deviate from a trajectory toward the phosphor layer 4, again move toward the phosphor layer 4. If the reflected electrons Er deviate from the phosphor layer 4 and collide with the semiconductor photodetection element 5, a peripheral wiring portion, and the like, damage may occur to the semiconductor photodetection element 5.

In contrast, in the photodetector 1, the semiconductor photodetection element 5 is arranged to be separated from the phosphor layer 4. Thereby, when some of the electrons E emitted from the photoelectric surface 3 are reflected inside the vacuum housing 2 to become reflected electrons Er, even if the reflected electrons Er, which deviate from a trajectory toward the phosphor layer 4, again move toward the phosphor layer 4 due to the electric field in the vacuum housing 2, it is possible to reduce a possibility that the reflected electrons Er will collide with the semiconductor photodetection element 5. Therefore, in the photodetector 1, the semiconductor photodetection element 5 can be protected from the reflected electrons Er generated inside the vacuum housing 2.

In the present embodiment, the internal housing 6 surrounding the semiconductor photodetection element 5 is arranged inside the vacuum housing 2. Thereby, the reflected electrons Er directed toward the semiconductor photodetection element 5 can be physically blocked by the internal housing 6. Therefore, it is possible to more reliably prevent the reflected electrons Er from colliding with the semiconductor photodetection element 5.

In the present embodiment, the separation distance T of the semiconductor photodetection element 5 from the phosphor layer 4 is defined by the internal housing 6. According to such a configuration, the separation distance between the phosphor layer 4 and the semiconductor photodetection element 5 can be formed as designed. Therefore, it is possible to more reliably reduce a possibility that the reflected electrons Er will collide with the semiconductor photodetection element 5.

In the present embodiment, the internal housing 6 has the hole 26 that causes the internal space S1 of the vacuum housing 2 and the internal space S2 of the internal housing 6 to communicate with each other. Thereby, when the vacuum housing 2 is evacuated, the evacuation of the internal housing 6 can be simultaneously performed via the hole 26. Thereby, the deterioration of the photoelectric surface 3 due to residual gas inside the vacuum housing 2 and the internal housing 6 can be suppressed.

In the present embodiment, the semiconductor photodetection element 5 is arranged on the bottom portion 23 of the internal housing 6, and the hole 26 is arranged, in the bottom portion 23, around the semiconductor photodetection element 5. According to such a configuration, the hole 26 of the internal housing 6 and the semiconductor photodetection element 5 can be brought sufficiently close to each other. Therefore, even if the internal housing 6 has the hole 26, it is possible to suppress the collision of the reflected electrons Er with the semiconductor photodetection element 5 through the hole 26.

In the present embodiment, the chip tube 16 serving as an exhaust port of the vacuum housing 2 and an introduction port for an alkali for use in alkalization of the photoelectric surface 3 is provided on the bottom portion 23 of the vacuum housing 2. Also, the chip tube 16 is arranged at a position that does not overlap the internal housing 6 in a front view of the window part 12. According to such a configuration, a sufficient spacing can be formed between the hole 26 of the internal housing 6 and the chip tube 16. Therefore, even if the internal housing 6 has the hole 26, it is possible to suppress the adhesion of the alkali introduced from the chip tube 16 to the semiconductor photodetection element 5 through the hole 26. This contributes to the suppression of noise (such as a dark current) caused by the adhesion of the alkali to the semiconductor photodetection element 5.

In the present embodiment, the internal housing 6 is formed of a conductive material. Thereby, a field-free environment can be established inside the internal housing 6, and the formation of an electric field that directs the reflected electrons Er toward the semiconductor photodetection element 5 can be suppressed. Therefore, even if the reflected electrons Er move the inside the internal housing 6, a possibility that the reflected electrons Er will collide with the semiconductor photodetection element 5 can be sufficiently reduced.

In the present embodiment, in the phosphor layer 4, the metal layer 18 is arranged on a surface facing the photoelectric surface 3 side. Thereby, a component directed toward the photoelectric surface 3 within the light generated from the phosphor layer 4 can be reflected by the metal layer 18 and moved toward the semiconductor photodetection element 5. Therefore, the amount of light detected by the semiconductor photodetection element 5 can be increased.

In the present embodiment, the metal layer 18 is electrically connected to the internal housing 6. Thereby, power can be supplied to the metal layer 18 together with the internal housing 6. When power is supplied to the metal layer 18, the metal layer 18 can function as an electrode that forms an electric field for guiding the electrons E emitted from the photoelectric surface 3 to the phosphor layer 4.

In the present embodiment, the area P1 of the photoelectric surface 3 is larger than the area P2 of the phosphor layer 4, and the area P2 of the phosphor layer 4 is larger than the area P3 of the semiconductor photodetection element 5. In this case, it is possible to improve response characteristics of the semiconductor photodetection element 5 by reducing the area P3 of the semiconductor photodetection element 5. Although it is necessary to sufficiently secure the area P1 of the photoelectric surface 3 to improve collection efficiency of the light L1 in reducing the area P3 of the semiconductor photodetection element 5, it becomes unnecessary to focus the electrons E emitted from the photoelectric surface 3 onto a minute region by making the area P2 of the phosphor layer 4 interposed between the photoelectric surface 3 and the semiconductor photodetection element 5 larger than the area P3 of the semiconductor photodetection element 5. Because precise control of electron trajectories becomes unnecessary, the complication of the design of the photodetector 1 can be avoided.

In the present embodiment, the vacuum housing 2 is formed of a conductive material. Inside the vacuum housing 2, the focusing electrode 8 that focuses the electrons E emitted from the photoelectric surface 3 onto the phosphor layer 4 is arranged, and the focusing electrode 8 has the same potential as the vacuum housing 2. According to such a configuration, the electrons E emitted from the photoelectric surface 3 can be efficiently guided toward the phosphor layer 4. Moreover, such technical effects can be achieved with a simple configuration. In addition, the focusing electrode 8 and the vacuum housing 2 do not necessarily need to be at the same potential, and potentials different from each other may be applied thereto. In this case, more precise control of electron trajectories becomes possible.

In the present embodiment, the light guide member 7 that guides the light L2 generated from the phosphor layer 4 to the semiconductor photodetection element 5 is arranged between the phosphor layer 4 and the semiconductor photodetection element 5. By using the light guide member 7, the light L2 generated from the phosphor layer 4 can be efficiently guided toward the semiconductor photodetection element 5. Moreover, even if ions are generated due to a collision between residual gas inside the vacuum housing 2 and the electrons E, ions passing through the phosphor layer 4 toward the semiconductor photodetection element 5 can be physically blocked by the light guide member 7. Therefore, the semiconductor photodetection element 5 can be protected from ion collisions.

Ions generated by the collision between residual gas and electrons E may become a cause of a malfunction in the photodetector 1. For example, when negatively charged ions (negative ions) are generated, it is conceivable that the ions collide with the semiconductor photodetection element 5 along the same trajectory as the electrons E emitted from the photoelectric surface 3 toward the phosphor layer 4. In this case, the phosphor layer 4 or the semiconductor photodetection element 5 may be damaged, and characteristics may be degraded. Even if ionization is not performed, if residual gases such as water or hydrocarbons adhere to the semiconductor photodetection element 5, the degradation of characteristics may occur. Therefore, by physically protecting the semiconductor photodetection element 5 with the light guide member 7, the deterioration of characteristics of the semiconductor photodetection element 5 can be suppressed.

Next, examples of the present disclosure will be described.

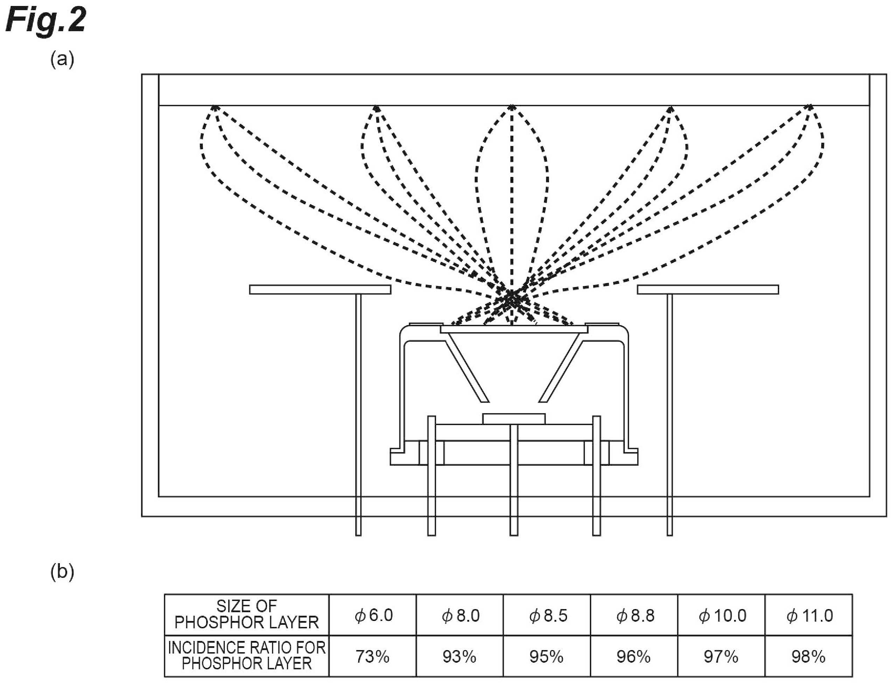

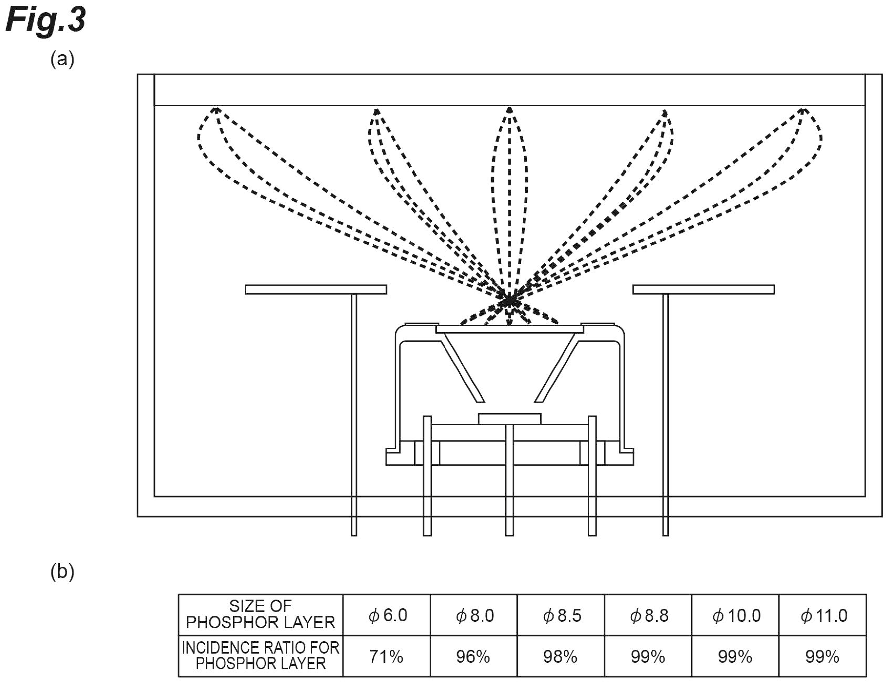

FIGS. 2(a), 2(b), 3(a), and 3(b) are diagrams showing simulation results of electron trajectories from the photoelectric surface toward the phosphor layer. In FIGS. 2(a) and 2(b), in a photodetector having a configuration equivalent to that of the above-described photodetector 1, a probability that electrons emitted from the photoelectric surface would be incident on the phosphor layer was calculated when a diameter of the photoelectric surface was set to 3 inches and a diameter of the phosphor layer was varied. Here, a voltage applied to the photoelectric surface and the focusing electrode was set to -2 kV, and the phosphor layer was set to a ground potential. As a result, when the diameter of the phosphor layer was 6 mm, the probability of electron incidence on the phosphor layer was less than 75%, whereas when the diameter of the phosphor layer was 8 mm or more, the probability of electron incidence on the phosphor layer exceeded 90% in all cases. In FIGS. 3(a) and 3(b), the voltage applied to the photoelectric surface and the focusing electrode was set to -3 kV, and other conditions were the same as those in FIGS. 2(a) and 2(b). As a result, when the diameter of the phosphor layer was 6 mm, the probability of electron incidence on the phosphor layer was less than 75%, whereas when the diameter of the phosphor layer was 8 mm or more, the probability of electron incidence on the phosphor layer exceeded 90% in all cases.

From these results, it can be understood that, when electrons emitted from the photoelectric surface are once converted into light by the phosphor layer, the electrons can be incident on the phosphor layer with high efficiency at an applied voltage of about -2 kV to -3 kV. Although a gain of about 1×10⁵ is required to detect a single electron and a voltage of about 10 kV is also required to be applied to the semiconductor detection element when electrons are directly focused onto a minute region of a semiconductor photodetection element, an operation at a lower voltage becomes possible in a configuration in which a phosphor layer is interposed between the photoelectric surface and the semiconductor photodetection element as in the present disclosure.

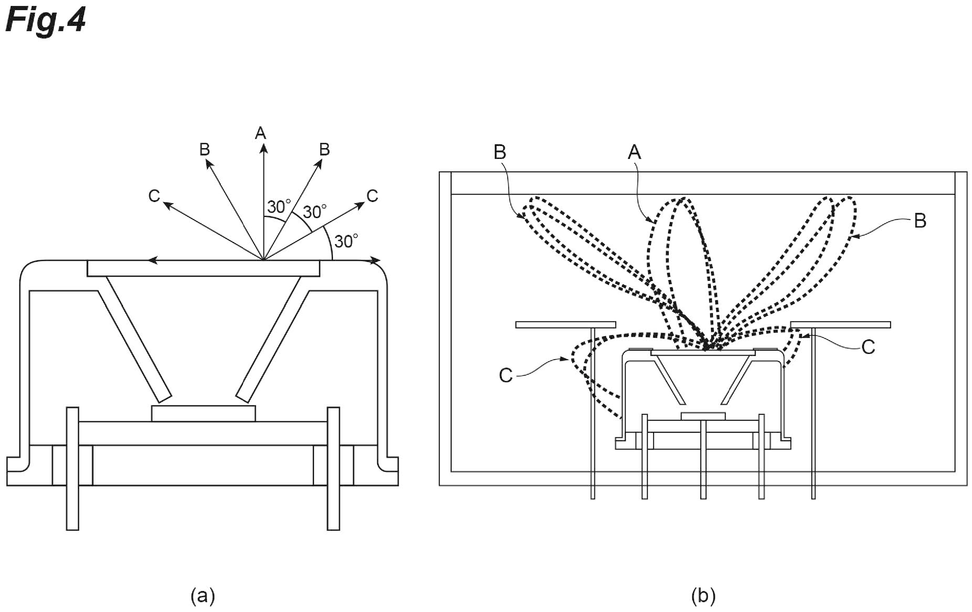

FIGS. 4(a) and 4(b) are diagrams showing simulation results of trajectories of reflected electrons generated from the surface of the phosphor layer. In this simulation, trajectories of reflected electrons generated from a half portion of the phosphor layer (the right half portion in FIG. 4(a)) were calculated. Here, as initial trajectories of the reflected electrons, as shown in FIG. 4(a), electrons moving perpendicularly from the surface of the phosphor layer 4 (reflected electrons A), electrons moving at an angle of 30° from a direction perpendicular to the surface of the phosphor layer 4 (reflected electrons B), and electrons moving at an angle of 60° from a direction perpendicular to the surface of the phosphor layer 4 (reflected electrons C) were set.

As shown in FIG. 4(b), after the reflected electrons A moved toward a region in the vicinity of a center of the photoelectric surface, they were reversed toward the phosphor layer and followed a trajectory mainly toward a left half portion of the phosphor layer. After the reflected electrons B moved toward a region in the vicinity of an edge portion of the photoelectric surface, they were reversed toward the phosphor layer and followed a trajectory mainly toward a right half portion of the phosphor layer. Among the reflected electrons C, electrons that moved at an angle of 60° to the right from the direction perpendicular to the surface of the phosphor layer 4 returned to the phosphor layer while drawing a convex curve toward the photoelectric surface and followed trajectories mainly toward the right half portion of the phosphor layer and the right-side surface portion of the internal housing. Among the reflected electrons C, electrons that moved at an angle of 60° to the left from the direction perpendicular to the surface of the phosphor layer 4 followed trajectories mainly toward the left half portion and the rear surface of the internal housing.

From these results, it can be seen that a possibility that reflected electrons will collide with the semiconductor photodetection element can be reduced according to a configuration in which the semiconductor photodetection element is arranged to be separated from the second photoelectric conversion layer. Moreover, it can be seen that reflected electrons directed toward the semiconductor photodetection element can be physically blocked by the internal housing, and the semiconductor photodetection element can be suitably protected, according to a configuration in which an internal housing that surrounds the semiconductor photodetection element is arranged inside the vacuum housing.

### Reference Signs List

1 Photodetector, 2 Vacuum housing, 3 Photoelectric surface (first photoelectric conversion layer), 4 Phosphor layer (second photoelectric conversion layer), 5 Semiconductor photodetection element, 6 Internal housing, 7 Light guide member, 8 Focusing electrode, 16 Chip tube, 18 Metal layer, 23 Bottom portion, 26 Hole, L1 Light serving as detection target, L2 Light generated from phosphor layer, T Separation distance, S1 Internal space of vacuum housing, S2 Internal space of internal housing

## Claims

1. A photodetector comprising:
a vacuum housing having a window part for causing light serving as a detection target to be incident;
a first photoelectric conversion layer arranged inside the vacuum housing and configured to emit electrons in accordance with incidence of the light;
a second photoelectric conversion layer arranged inside the vacuum housing and configured to generate light in accordance with incidence of the electrons emitted from the first photoelectric conversion layer; and
a semiconductor photodetection element arranged on an opposite side of the first photoelectric conversion layer so that the second photoelectric conversion layer is sandwiched inside the vacuum housing and configured to detect the light generated from the second photoelectric conversion layer,
wherein the semiconductor photodetection element is arranged to be separated from the second photoelectric conversion layer.

2. The photodetector according to claim 1, wherein an internal housing surrounding the semiconductor photodetection element is arranged inside the vacuum housing.

3. The photodetector according to claim 2, wherein a separation distance of the semiconductor photodetection element from the second photoelectric conversion layer is defined by the internal housing.

4. The photodetector according to claim 2 or 3, wherein the internal housing has a hole that causes an internal space of the vacuum housing and an internal space of the internal housing to communicate with each other.

5. The photodetector according to claim 4,
wherein the semiconductor photodetection element is arranged on a bottom portion of the internal housing, and
wherein the hole is formed, in the bottom portion, around the semiconductor photodetection element.

6. The photodetector according to claim 4 or 5,
wherein a chip tube serving as an exhaust port of the vacuum housing and an introduction port for an alkali for use in alkalization of the first photoelectric conversion layer is provided on a bottom portion of the vacuum housing, and
wherein the chip tube is arranged at a position that does not overlap the internal housing in a front view of the window part.

7. The photodetector according to any one of claims 2 to 6, wherein the internal housing is formed of a conductive material.

8. The photodetector according to any one of claims 2 to 7, wherein, in the second photoelectric conversion layer, a metal layer is arranged on a surface facing the first photoelectric conversion layer.

9. The photodetector according to claim 8, wherein the metal layer is electrically connected to the internal housing.

10. The photodetector according to any one of claims 1 to 9,
wherein an area of the first photoelectric conversion layer is larger than that of the second photoelectric conversion layer, and
wherein an area of the second photoelectric conversion layer is larger than that of the semiconductor photodetection element.

11. The photodetector according to any one of claims 1 to 10,
wherein the vacuum housing is formed of a conductive material,
wherein a focusing electrode that focuses the electrons emitted from the first photoelectric conversion layer onto the second photoelectric conversion layer is arranged inside the vacuum housing, and
wherein the focusing electrode has the same potential as the vacuum housing.

12. The photodetector according to any one of claims 1 to 11, wherein a light guide member, which guides the light generated from the second photoelectric conversion layer to the semiconductor photodetection element, is arranged between the second photoelectric conversion layer and the semiconductor photodetection element.
